Europäisches Patentamt

European Patent Office

Office européen des brevets

(11) Veröffentlichungsnummer: **0 065 299**
A2

# EUROPÄISCHE PATENTANMELDUNG

(21) Anmeldenummer: 82104256.1

(22) Anmeldetag: 14.05.82

(51) Int. Cl.³: **H 05 K 13/00,** H 05 K 13/08

(30) Priorität: 18.05.81 DE 3119686

(43) Veröffentlichungstag der Anmeldung: 24.11.82
Patentblatt 82/47

(84) Benannte Vertragsstaaten: DE FR GB

(71) Anmelder: SIEMENS AKTIENGESELLSCHAFT Berlin und München, Postfach 22 02 61,
D-8000 München 22 (DE)

(72) Erfinder: Ertl, Wilhelm, Sudetenstrasse 25,
D-8012 Ottobrunn (DE)

(54) Be- und Entstückautomat für Bauelemente.

(57) Die Erfindung betrifft einen Be- und Entstückautomaten für Bauelemente, insbesondere integrierte Schaltkreise, bei dem zur Entnahme der Bauelemente (32) aus einem Vorratsbehälter (31) und zum Einstecken der Bauelemente (32) in eine Halteeinrichtung (33) ein Bestückkopf (2) vorgesehen ist, zur Entnahme der Bauelemente (32) aus der Halteeinrichtung (33) und zur Weitergabe der Bauelemente (32) ein Entstückkopf (5) vorgesehen ist und bei dem zur Bewegungsablaufsteuerung von Be- und Entstückkopf (2, 5) eine Nockensteuerung (17, 21) vorgesehen ist.

SIEMENS AKTIENGESELLSCHAFT
Berlin und München

Unser Zeichen
VPA 81 P 1069 E

0065299

**Be- und Entstückautomat für Bauelemente**

Die Erfindung betrifft einen Be- und Entstückautomat für
Bauelemente, insbesondere integrierte Schaltkreise.

Bestückungsautomaten, mit deren Hilfe Leiterplatten mit
Bauelementen wie Widerständen, Kondensatoren, Einzelhalbleitern oder integrierten Schaltkreisen bestückt
werden, sind bekannt. Diese Automaten arbeiten in der
Regel pneumatisch und vermögen lediglich eine Bestückung
der Leiterplatten mit Bauelementen, nicht aber eine Entstückung.

Zum Testen von integrierten Schaltkreisen auf Funktionsfähigkeit werden in der Regel computergesteuerte Testgeräte verwendet, an die eine auf den speziellen, zu prüfenden Schaltkreistyp abgestimmte Prüfkartenplatine anschließbar ist. Da zum Prüfen von Bauelementen mit kleinen Zugriffszeiten nur geringe Prüfleitungslängen verwendet werden können, sind die Prüfkarten i. a. direkt
auf dem Testgerät anordenbar. Die zu prüfenden Schaltkreise werden von Hand in auf den Prüfkartenplatinen angeordnete Meßfassungen eingesteckt und nach erfolgter
Messung je nach Prüfergebnis von Hand sortiert. Dieses
Verfahren erfordert einen hohen zeitlichen Aufwand, es
führt somit zu einer schlechten Auslastung der Testgeräte. Beim Einstecken von insbesondere mit zahlreichen
Anschlußstiften versehenen Schaltkreisen, beispielsweise IC's mit in zwei Reihen angeordneten Anschlüssen
(dual-in-line-package) kann das Einsetzen und Entfernen
der integrierten Schaltkreise in bzw. aus der Meßfassung
zum Verbiegen der Anschlußstifte und somit zu Problemen
bei der späteren Bestückung einer Schaltkarte mit diesem
Schaltkreis führen. Das Sortieren von Hand der geprüften

Nte 1 Kth / 11.05.1981

IC's kann ferner zu Fehlern z. B. durch Vertauschen führen.

Aufgabe der vorliegenden Erfindung ist es, hier Abhilfe zu schaffen und einen Be- und Entstückungsautomaten vorzusehen, der auf einen der beschriebenen Handmeßplätze aufsetzbar ist, ohne daß ein elektrischer oder mechanischer Eingriff bezüglich des Handmeßplatzes erforderlich ist.

Diese Aufgabe wird erfindungsgemäß dadurch gelöst, daß zur Entnahme der Bauelemente aus einem Vorratsbehälter und zum Einstecken der Bauelemente in eine Halteeinrichtung ein Bestückkopf vorgesehen ist, daß zur Entnahme der Bauelemente aus der Halteeinrichtung und zur Weitergabe der Bauelemente ein Entstückkopf vorgesehen ist und daß zur Bewegungsablaufsteuerung von Be- und Entstückkopf eine Nockensteuerung vorgesehen ist. Auf diese Weise gelingt es, einen kompakten Be- und Entstückautomaten zu schaffen, der mit einem kontinuierlich laufenden Motor antreibbar ist, sicher und präzis arbeitet und mit dem entsprechend der kurzen Meßzeiten handelsüblicher Testautomaten kurze Taktzeiten zu verwirklichen sind.

Zur Vereinfachung der Mechanik ist es von Vorteil, die zur Steuerung des Entstückkopfes verwendeten Nocken auf einer gemeinsamen, mittels eines Motors antreibbaren Achse anzuordnen.

Jeder Kopf (Be- und Entstückkopf) wird vorzugsweise an seiner dem Bauelement zugewandten Seite mit einer, mittels von Öffnungsnocken betätigbaren Öffnungshebeln und -schubstangen zu öffnen Zange zum Fassen der Bauelemente versehen.

0065299

Es liegt im Rahmen der Erfindung, daß die Zangen zum Ausführen einer Hubbewegung mittels von Höhenverstellnocken betätigbaren Höhenverstellhebeln und -schubstangen bezüglich ihres Abstandes zur Halteeinrichtung höhenverstellbar ausgeführt sind, daß die Zangen zum Ausführen einer Drehbewegung mittels von Zangenbetätigungsnocken betätigbaren Zangendrehhebeln und -schubstangen mindestens in der Ebene, in der die Halteeinrichtung angeordnet ist, drehbar ausgeführt sind, daß die Zangen zur Aufnahme der Bauelemente aus einem Vorratsbehälter oder zur Ablage der Bauelemente in einer zur Ebene, in der die Halteeinrichtung angeordnet ist, senkrechten Ebene drehbar ausgeführt sind, und daß zur raumsparenden Anordnung des Be- und Entstückautomaten die Zangen in einer, bezüglich der Ebene, in der die Halteeinrichtung angeordnet ist, parallele Ebene verschiebbar ausgeführt sind.

Weitere Ausgestaltungen des erfindungsgemäßen Be- und Entstückautomaten sind in Unteransprüchen gekennzeichnet.

Die Erfindung wird im folgenden anhand der Figuren näher erläutert. Dabei zeigen:

die Fig. 1 eine als Ausführungsbeispiel zu wertende schematische Darstellung eines erfindungsgemäßen Automatens,

die Fig. 2 schematisch ein Ausführungsbeispiel für eine beim erfindungsgemäßen Automaten anwendbare Nockensteuerung,

die Fig. 3 bis 7 Ausführungsbeispiele für die mechanische Ausführung dreier Bewegungsabläufe eines Be- oder Entstückkopfes und

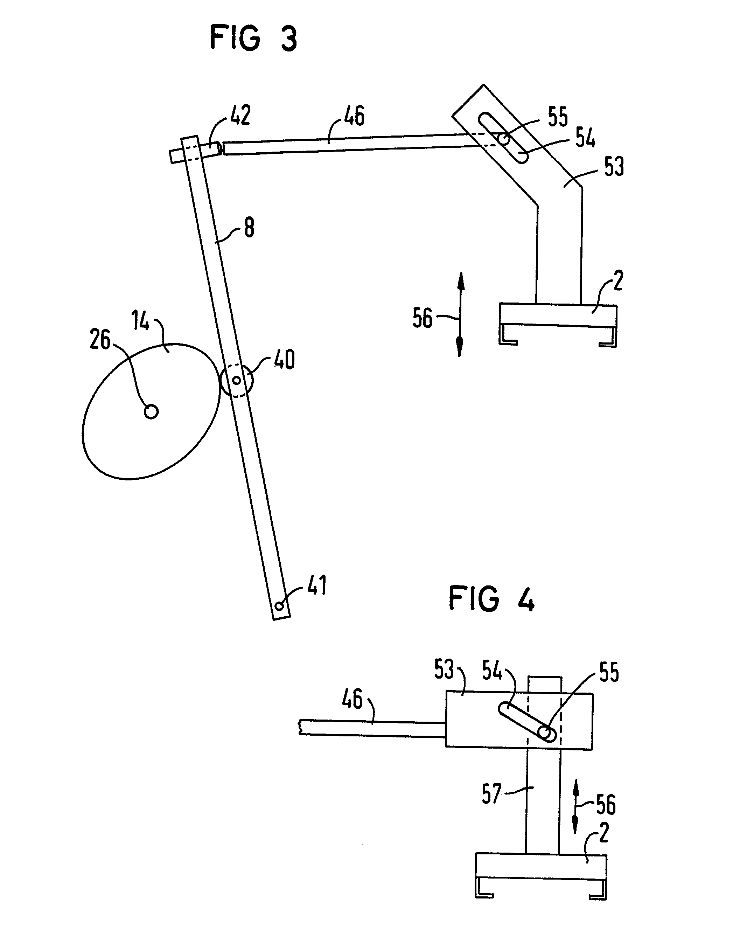

die Fig. 3 ein Ablaufdiagramm zum Betreiben des erfindungsgemäßen Automaten.

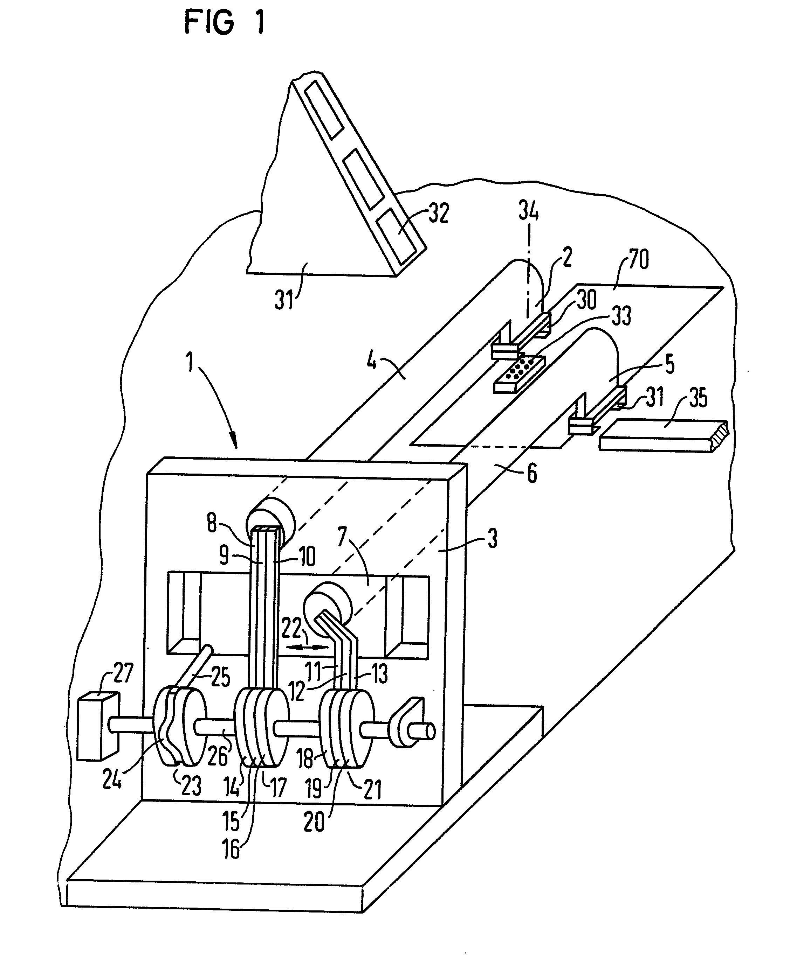

Die vereinfacht dargestellte, schematische Darstellung eines Ausführungsbeispiels eines erfindungsgemäßen Be-und Entstückungsautomaten 1 der Fig. 1 zeigt einen Bestückkopf 2, der an einem Ende eines, in einem Metallrahmen 3 fixierten Tragrohres 4 angeordnet ist. Der Entstückkopf 5 ist entsprechend an einen zweiten Tragrohr 6, das in einem Schlitten 7 gehaltert ist, angeordnet. In den Tragrohren 4 und 6 befinden sich in der Fig. 1 aus Gründen der Übersichlichkeit nicht dargestellte Schubstangen, die über an, den Köpfen 2, 5 gegenüberliegenden Enden der Tragrohre 4, 6 angeordneten, mittels von Nocken bewegbaren Hebeln 8, 9, 10 bzw. 11, 12, 13 betätigbar sind. Die drei Hebel 8 bis 10 werden über drei Nocken 14, 15, 16, die zu einem Nockenpaket 17 zusammengefaßt sind, betätigt, während die Hebel 11 bis 13 über die Nocken 18 bis 20, die zu einem zweiten Nockenpaket 21 zusammengefaßt sind, betätigt werden. Zum Verschieben des das Tragrohr 6 halternden Schlittens 7 entsprechend dem Pfeil 22 parallel zur Achse des Tragrohrs 6 ist ein weiteres Nockenpaket 23 vorgesehen, das eine Kulisse 24 aufweist, in die ein mit dem Schlitten 7 starr verbundenes Abrollager 25 eingreift. Über das Nockenpaket 23 ist ferner mittels einer aus Gründen der Übersichtlichkeit in der Fig. 1 nicht dargestellten Mechanik das Tragrohr 4 und damit der Bestückkopf 2 und seine Achse drehbar.

Die drei Nockenpakete 17, 21 und 23 sind auf einer gemeinsamen Keilwelle 26 angeordnet, die über einen Motor 27 antreibbar ist. Während die Nockenpakete 17 und 23 starr mit der Keilwelle verbunden sind, ist das Nockenpaket 21 entsprechend der Verschiebung des Schlittens 7 auf der Keilwelle 26 verschiebbar. Der die Anordnung 1 halternde Rahmen 3 ist zur justierbaren Verschiebung auf einen in x- und y-Richtung und Höhe verstellbaren, in der Fig. nicht dargestellten Kreuztisch angeordnet.

Der erfindungsgemäße Be- und Entstückautomat arbeitet in der Weise, daß mittels der am Ende des Bestückkopfes 2 angeordnete Zange 30 aus einem Vorratsbehälter 31 ein

0065299

Bauelement 32, beispielsweise ein IC mit einem Dual-in-line-Gehäuse stirnseitig gepackt und aufgenommen wird, die Zange 30 um die Achse des Tragrohres 4 zur Meßfassung 33 hingeschwenkt wird und gegebenenfalls die Zange 30 gleichzeitig um 90°C um die Achse 34 des Bestückkopfes 2 gedreht wird und anschließend die Zange 30 so gesenkt wird, daß das Bauelement 32 in die auf einer Meßkarte 70 angeordnete Fassung 33 eingesetzt wird. Sodann wird die Zange 30 wieder zum Ergreifen des nächsten Bauelementes 32 in Richtung Vorratsbehälter 31 bewegt. Nach erfolgter Messung des Bauelementes 32 wird dieses mittels der am unteren Ende des Entstückkopfes 5 befindlichen Zange 31 ergriffen und durch Hochziehen der Zange 31 aus der Fassung 33 gezogen. Durch eine Parallelverschiebung des Tragrohres 6 in Pfeilrichtung 22 wird einerseits das Einstecken des nächsten Bauelementes in die Fassung 33 mittels der Zange 30 ermöglicht und andererseits das in der Zange 31 befindliche Bauelement über eine Schiene 35 geführt und nach Senken und Öffnen der Zange 31 auf der Schiene 35 abgelegt. Auf der Schiene 35 kann das gemessene Bauelement weitergeführt, und beispielsweise zu Sortierzwecken einer Drehscheibe, die entsprechend den vorgesehenen Qualitätsstufen mit mehreren weiteren Schienen verbunden ist, zugeführt werden.

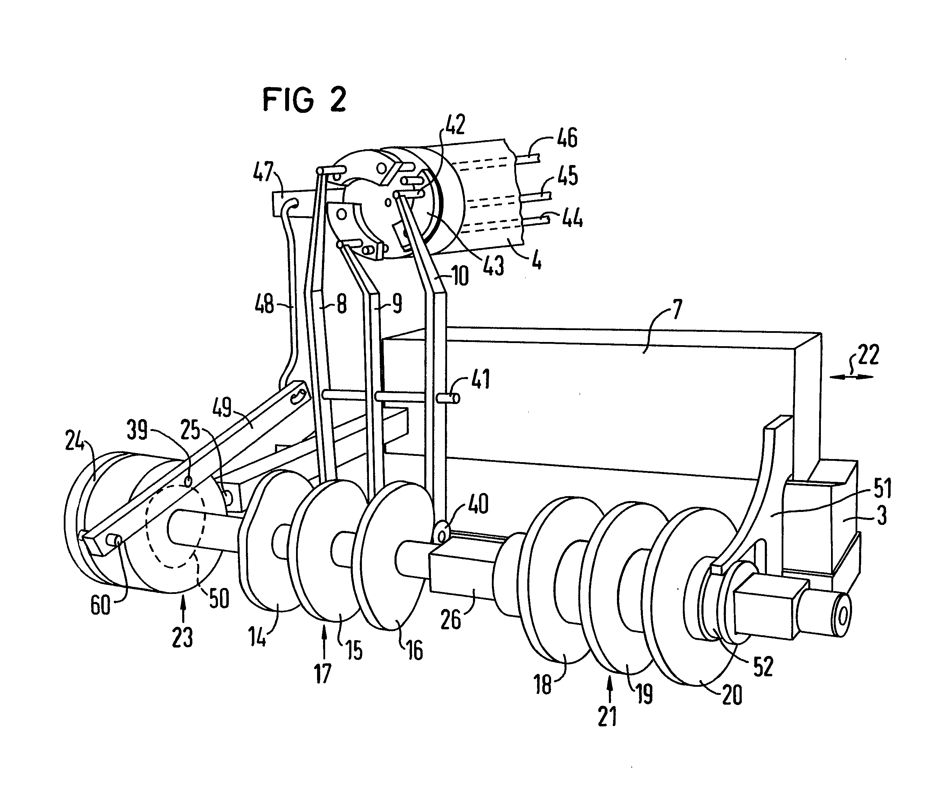

Die Fig. 2 zeigt ein Ausführungsbeispiel einer beim erfindungsgemäßen Be- und Entstückautomaten 1 vorgesehenen Nocken- und Hebelanordnung zur Betätigung des Bestückkopfes 2 und des Entstückkopfes 5. Entsprechend der Fig. 1 werden gleiche Teile mit gleichen Bezugszeichen bezeichnet. Auf der Keilwelle 26 sind die drei Nockenpakete 23, 17 und 21 angeordnet. Die drei Nocken 14, 15, 16 des Nockenpaketes 17 betätigen die zur Bewegung der Zange 30 des Bestückkopfes 2 benötigten Hebel 8, 9, 10. Die Hebel 8, 9, 10 sind um einen, von der starr mit dem Rahmen 3 verbundenen Stange 41 gebildeten Fix- bzw Massepunkt drehbar. Die Drehung wird durch die, von der Kreissymmetrie

0065299

abweichende Gestaltung der Nocken 14, 15, 16, die zur Verringerung der Reibung die Hebel 8, 9, 10 über Abrolllager 40 betätigen, in an sich bekannter Weise ermöglicht. Die Enden der Hebel 8, 9, 10 sind über Justierschrauben 42 mit Druckplatten 43 verbunden, die mit den zur Betätigung des Bestückkopfes benötigten Schubstangen 44, 45, 46 starr verbunden sind. So ist durch Drehung der Höhenverstellnocke 14 der Höhenverstellhebel 8 bewegbar, der die Höhenverstellschubstange 46 längs der Achse des Tragrohrs 4 bewegt, durch Drehung der Öffnungsnocke 15 ist über den Öffnungshebel 9 die Öffnungsschubstange 44 bewegbar, während durch Drehung der Zangendrehnocke 16 über den Zangendrehhebel 10 die Zangendrehschubstange 45 bewegbar ist. Die Hebel 8, 9, 10 werden in der Weise federnd beaufschlagt, daß die Abrolllager 40 an den Nocken 14, 15, 16 anliegen.

Das Tragrohr 4 bzw. ein innerhalb des Tragrohrs 4 befindliches, in der Fig. nicht dargestelltes inneres Rohr ist mittels des Hebels 47 um die Achse des Tragrohres 4 um z. B. 60° drehbar. Zu diesem Zwecke ist der Hebel 47 mittels der Verbindungsstange 48 mit dem einen Ende eines weiteren Hebels 49 verbunden, dessen anderes Ende als Fixpunkt 60 starr mit dem Rahmen 3 verbunden ist und der in seinem mittleren Bereich mit einem Abrollpunkt 39 versehen ist, der auf einer zum Nockenpaket 23 gehörigen Nocke 50 abrollt.

Die zum Nockenpaket 21 gehörigen Nocken 18, 19, 20 beaufschlagen entsprechend den zur Betätigung des Bestückkopfes 2 vorgesehenen Hebel 8, 9, 10 und Schubstangen 44, 45, 46 aus Gründen der Übersichtlichkeit in der schematischen Fig. 2 nicht dargestellte zur Betätigung des Entstückkopfes 5 dienende Hebel 11, 12, 13. Im Gegensatz zu den Nockenpaketen 17 und 23, die starr auf der Welle 26 angeordnet sind, ist das Nockenpaket 21 axial zur Welle 26 verschiebbar. Die Verschiebung in Pfeilrichtung 22

0065299

geschieht in der Weise, daß im Nockenpaket 23 eine, eine Kulisse 24 aufweisende Nocke vorgesehen ist, in die ein starr mit dem Schlitten 7 verbundenes Abrollager 25 eingreift. Der Schlitten 7 ist widerrum starr mit einem Winkel 51 verbunden, der zur Verschiebung des Nockenpaketes 21 in eine am Nockenpaket 21 angeordnete Nut 52 eingreift. Entsprechend der Gestaltung der Kurve der Kulisse 24 wird also das Nockenpaket 21 auf der Keilwelle 26 axial verschoben.

Die einzelnen Bewegungsabläufe der Köpfe 2 und 5 können z. B. wie in den Fig. 3 bis 7 gezeigt mechanisch gesteuert werden. Der in der Fig. 3 gezeigte Mechanismus dient der Höhenverschiebung (Pfeilrichtung 56) des Bestückkopfes 2 bzw. des Entstückkopfes 5. Die Höhenverstellnocke 14 betätigt den einen Fixpunkt 41 und ein Abrollager 40 aufweisenden Verstellhebel 8. Über die Justierschraube 42 bewegt der Höhenverstellhebel 8 die im Tragrohr 4 befindliche Schubstange 46 in Längsrichtung. Die Schubstange 46 endet mittels eines Kugellagers 55 in einer in einer Platte 53 entsprechend einer schiefen Ebene angeordneten Kulisse 54. Der Bestückkopf ist mit der Platte 53 starr verbunden. Bei einer Bewegung der Höhenverstellschubstange 46 nach rechts bewegt sich somit der Bestückungskopf 2 nach oben, während er sich bei einer Bewegung der Höhenverstellschubstange 46 nach links nach unten bewegt. Die zur Führung der Anordnung notwendigen Vorrichtungen sind in der Fig. 3 und den weiteren Fig. aus Gründen der Übersichtlichkeit nicht dargestellt.

Eine entsprechende mechanische Anordnung ist zur Höhenverstellung des Entstückkopfes 5 vorgesehen.

Eine alternativ zu dem in der Fig. 3 gezeigten Mechanismus verwendbare Höhenverstellung zeigt die Fig. 4. Hier ist das Ende der Schubstange 46, an dem sich der Bestückungskopf 2 befindet, starr mit der Platte 53 verbunden.

In der Platte 53 befindet sich wiederum eine entsprechend einer schiefen Ebene angeordnete Kulisse 54. In die Kulisse 54 greift ein an der Keilwelle 57 angeordnetes Kugellager 55 ein. Am unteren Ende der Keilwelle 57 ist der Bestückungskopf 2 angeordnet, die Keilwelle 57 ist zur Aufnahme des weiter unten beschriebenen Druckstiftes 65 durchbohrt.

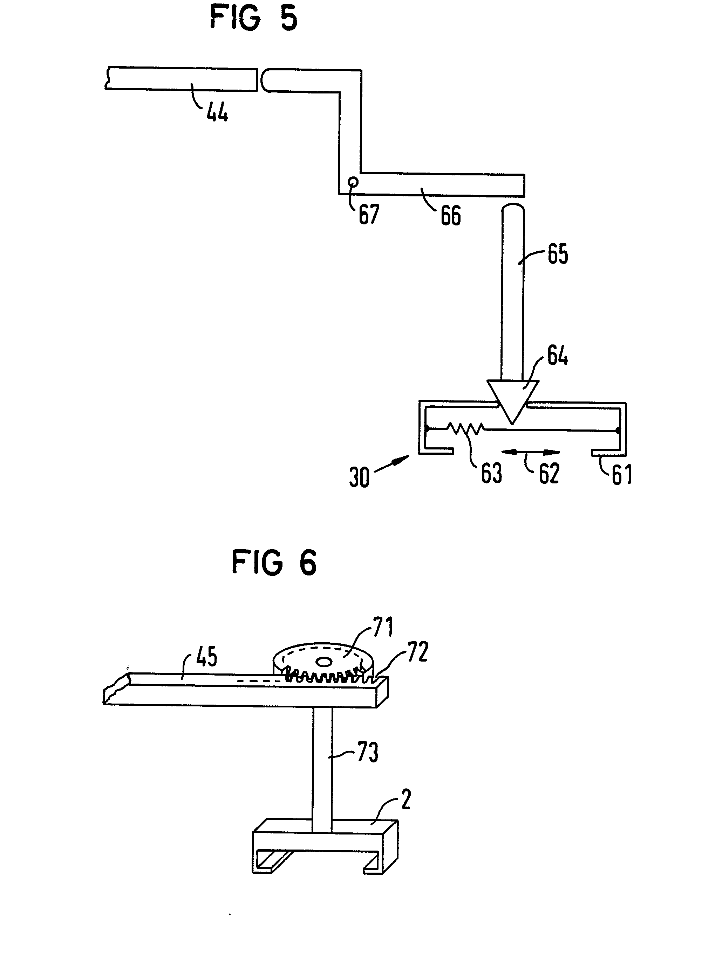

Die zur Betätigung des Öffnungs- bzw. Schließmechanismus der Zange 30 vorgesehene Mechanik ist in der Fig. 5 schematisch gezeigt. Die entsprechend der Fig. 3 über Nocke 15 und Hebel 9 betätigte Öffnungsschugstange 44 wirkt über einen einen Drehpunkt 67 aufweisenden Übertragungshebel 66 auf einen Stift 65 in der Weise, daß eine Längsbewegung der Öffnungsschubstange 44 einer Höhenbewegung des Stiftes 65 entspricht. Der Stift 65 ist starr mit einem Kegel 64 verbunden, der in der Weise zwischen die mittels einer Feder 63 zusammendrückbaren Zangenbacken 61 der Zange 30 schiebbar ist, daß bei einer Abwärtsbewegung des Kegels 64 die Zangen geöffnet werden, während bei einer Aufwärtsbewegung des Kegels 64 die Zangenbacken 61 mittels der Feder 63 geschlossen werden.

Entsprechendes gilt für die Betätigung der Zange 31 des Entstückkopfes 5.

Da die Anordnung der Meßfassung 33 auf der Meßkarte 70 nicht festliegt, sondern je nach Ausführung der zu einem speziellen Bauelement gefertigten Meßkarte in Längs- oder Querrichtung liegen kann, ist es erforderlich, die Köpfe 2 und 5 gegebennenfalls z. B. um 90° um ihre Achse zu drehen (Achse 34 für Bestückungskopf 2). Ein Ausführungsbeispiel einer dafür benötigten mechanischen Anordnung ist in Fig. 5 dargestellt. Die Zangendrehschubstange 45 wird wie in der Fig. 3 gezeigten Weise über eine Nocke 16 und einen Hebel 10 in Längsrichtung verschoben. Die Zangenschubstange 45 weist an ihrem, dem Bestückungskopf 2 zugewandtem Ende eine Zahnstange bzw. Zahnstege 72 auf, die bei einer Längsverschiebung der Stange 45 ein Zahnrad 71 drehen. Die Achse des Zahnrades 71 ist als Keilbuchse 73 ausgeführt und so mit dem Bestückungskopf 2 verbunden, daß eine Längsbewegung der Stange 45 einer Drehung des Bestückungskopfes 2 um die Achse der Keilwelle 73 entspricht.

Entsprechendes gilt für die Ausführung der Mechanik zum Drehen des Entstückkopfes 5.

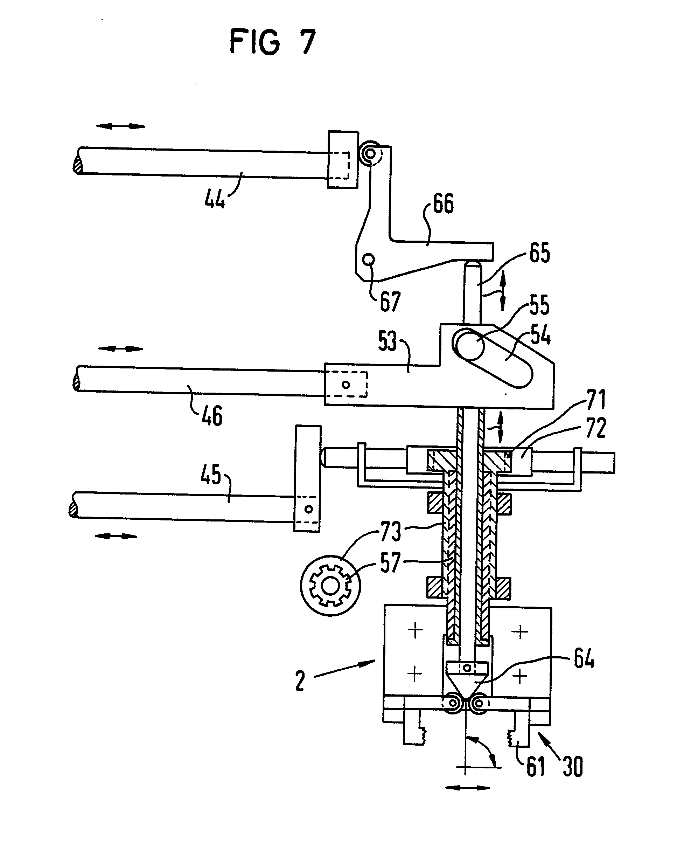

Ein Beispiel für das Zusammenwirken der in den Figuren 4, 5 und 6 gezeigten Bewegungsmechanismen zeigt Fig. 7, wobei die gleichen Bezugszeichen wie in den Fig. 1 bis 6 verwendet werden.

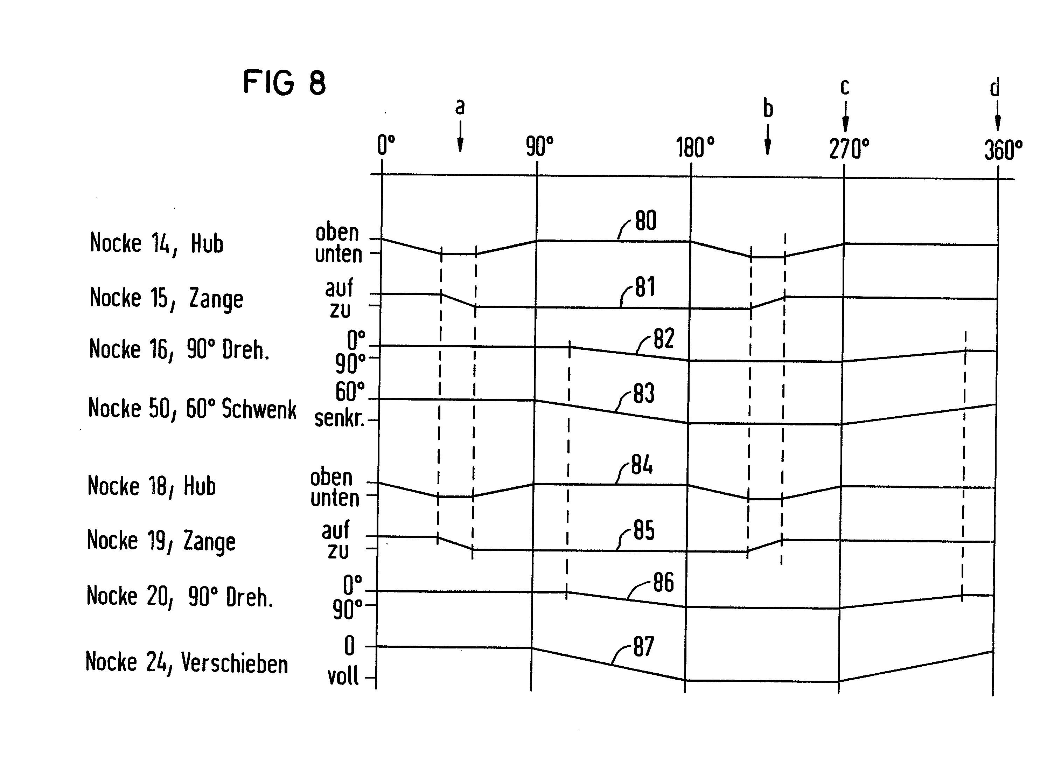

Die Fig. 8 zeigt das Zeitdiagramm für Nockenablauf bzw. Be- und Entstückkopfbewegung während einer 360°-Drehung der Welle 26. Die Kurven 80 bis 83 betreffen Bewegungen des Bestückkopfes 2, während die Kurven 84 bis 87 Bewegungen des Entstückkopfes darstellen. Die Kurve 80 zeigt die, von der Höhenverstellnocke 14 bewirkte Höhenverstellung des Kopfes 2 bzw. der Zange 30 mit den Extremstellungen "oben" und "unten". Die Kurve 81 zeigt den, von der Öffnungsnocke 15 gesteuerten Zustand der Zange 30 mit den Extremstellungen "auf" und "zu". Die von der Zangendrehnocke 16 gesteuerte Drehbewegung der Zange 30 um die Achse 34 mit den Extremstellungen 0° und 90° wird mit der Kurve 82 gezeigt. Die von der Nocke 50 gesteuerte Schwenkbewegung um beispielsweise 60° des Kopfes 2 mit den Extremstellungen 60° (zum Vorratsbehälter 31 hin) und "senkrecht" zeigt die Kurve 83.

Entsprechend für den Entstückkopf 5 bzw. die Zange 31 zeigen die Kurve 84 die Hubbewegung des Kopfes 5, die von der Nocke 18 gesteuert ist, die Kurve 85 die Zangenöffnung, die von der Nocke 19 gesteuert ist und die Kur-

0065299

ve 86 die 90° Drehung der Zange 31, die von der Nocke 20 gesteuert ist. Die von der Nocke 24 gesteuerte Verschiebung des Kopfes 5 (Pfeilrichtung 22) wird durch die Kurve 87 angezeigt.

Man erkennt, daß in etwa zum Winkel bzw. zum Zeitpunkt a von der Zange 30 ein Bauelement 32 aus dem Vorratsbehälter 31 gegriffen wird und in etwa zum Zeitpunkt b in die Meßfassung 33 eingesteckt wird. Gleichzeitig wird in etwa zum Zeitpunkt a ein bereits geprüftes Bauelement 32 durch den Entstückkopf 2 aus der Meßfassung 33 gegriffen und in etwa zum Zeitpunkt b auf der Sortierschiene 35 abgelegt. Die Messung selber kann zum Zeitpunkt c beginnen und beispielsweise bis zum Zeitpunkt d dauern. Die einzelnen Zeitpunkte sind durch entsprechende Nockenformgebung exakt steuerbar.

Durch das simultane Arbeiten des Bestückkopfes 2 und des Entstückkopfes 5 wird die für einen Zyklus (360°) benötigte Zeit im Vergleich zu separat arbeitenden Köpfen halbiert. Durch die mittels Formung der Nocken mögliche sinusförmige Steuerung der Bewegungen wird ein schonender Maschinenlauf und eine schonende Bauelementbehandlung ermöglicht. Zur Materialschonung trägt ferner bei, daß der als Elektro-oder Hydraulikmotor ausführbare Motor 27 konstant weiterlaufen kann, so daß im Vergleich mit pneumatisch betriebenen Geräten der erfindungsgemäße Automat eine höhere Lebensdauer aufweist. Während mit pneumatischen Geräten in der Regel nur Zykluszeiten von 2-3 Sekunden erreichbar sind, arbeitet der erfindungsgemäße Automat bei einer Taktzeit von 0,9 Sekunden störungsfrei im Dauerbetrieb. Im Vergleich zu handbetriebenen Meßplätzen konnte sowohl der Durchsatz als auch die Lieferqualität um den Faktor 3 verbessert werden. Durch die kompakte Bauweise kann der erfindungsgemäße Automat auf jeden Handmeßplatz aufgesetzt werden, ohne daß ein elektrischer oder mechanischer Eingriff in einen be-

0065299

reits vorher vorhandenen Handmeßplatz ausgeführt werden muß, wodurch es auch ermöglicht wird, die Leitungslänge zwischen Meßkarte 70 und Testgerät gering zu halten und somit Bauelemente mit extrem kleiner Zugriffszeit zu testen.

8 Figuren
11 Patentansprüche

## Patentansprüche

1. Be- und Entstückautomat für Bauelemente, insbesondere integrierte Schaltkreise, d a d u r c h  g e k e n n - z e i c h n e t ,  daß· zur Entnahme der Bauelemente (32) aus einem Vorratsbehälter (31) und zum Einstecken der Bauelemente (32) in eine Halteeinrichtung (33) ein Bestückkopf (2) vorgesehen ist,
daß zur Entnahme der Bauelemente (32) aus der Halteeinrichtung (33) und zur Weitergabe der Bauelemente (32) ein Entstückkopf (5) vorgesehen ist
und daß zur Bewegungsablaufsteuerung von Be- und Entstückkopf (2, 5) eine Nockensteuerung (17, 21) vorgesehen ist.

2. Be- und Entstückautomat nach Anspruch 1, d a - d u r c h  g e k e n n z e i c h n e t ,  daß die zur Steuerung verwendeten Nocken (17, 21, 23) auf einer gemeinsamen mittels eines Motors (27) antreibbaren Achse (26) angeordnet sind.

3. Be- und Entstückautomat nach Anspruch 1 oder 2, d a - d u r c h  g e· k e n n z e i c h n e t ,  daß jeder Kopf (2, 5) an seiner dem Bauelement (32) zugewandten Seite mit einer mittels von Öffnungsnocken (15, 19) bestätigbaren Öffnungshebeln (9, 12) und - Schubstangen (44) zu öffnenden Zange (30, 31) zum Fassen des Bauelementes (32) versehen ist.

4. Be- und Entstückautomat nach einem der Ansprüche 1 bis 3, d a d u r c h  g e k e n n z e i c h n e t ,  daß die Zange (30) mittels eines, von einer Höhenverstellnocke (40) bestätigbaren Höhenverstellhebels (8) und einer Höhenverstellschubstange (46) bezüglich ihres Abstandes zur Halteeinrichtung (33) höhenverstellbar ausgeführt ist.

5. Be- und Entstückautomat nach einem der Ansprüche 1 bis 4, d a d u r c h   g e k e n n z e i c h n e t, daß die Zange (30) mittels einem, von einer Zangenbetätigungsnocke (15) betätigbaren Zangendrehhebels (9) und einer Zangendrehschubstange (44) mindestens in der Ebene, in der die Halteeinrichtung (33) angeordnet ist, ausgeführt ist.

6. Be- und Entstückautomat nach einem der Ansprüche 1 bis 5, d a d u r c h   g e k e n n z e i c h n e t, daß die Zange (30) in einer zur Ebene, in der die Halteeinrichtung (33) angeordnet ist, senkrechten Ebene drehbar ausgeführt ist.

7. Be- und Entstückautomat nach einem der Ansprüche 1 bis 6, d a d u r c h   g e k e n n z e i c h n e t, daß die Zange (30) in einer, bezüglich der Ebene, in der die Halteeinrichtung (33) angeordnet ist, parallelen Ebene verschiebbar ausgeführt ist.

8. Be- und Entstückautomat nach einem der Ansprüche 1 bis 7, d a d u r c h   g e k e n n z e i c h n e t, daß die Zange (30) zum Fassen des Bauelementes (32) aus zwei Zangenbacken (61) besteht, daß die beiden Zangenbacken (61) mittels einer Feder (63) aneinander drückbar sind und daß die beiden Zangenbacken (61) mittels eines Kegels (64), der mittels eines von der Öffnungsschubstange (44) betätigbaren Übertragungshebels (66) zwischen die beiden Zangenbacken (61) drückbar ist, auseinander drückbar sind.

9. Be- und Entstückautomat nach einem der Ansprüche 1 bis 8, d a d u r c h   g e k e n n z e i c h n e t, daß die Zange (30) mit einer, mit einer Kulisse (54), in die die Höhenverstellschubstangen (46) eingreift, versehenen Platte (53) verbunden ist.

0065299

10. Be- und Entstückautomat nach einem der Ansprüche 1 bis 8, d a d u r c h  g e k e n n z e i c h n e t, daß die Zange (30) mit einer Keilwelle (57) verbunden ist, die in eine Kulisse, die mit der Höhenverstellschubstange (46) verbunden ist, eingreift.

11. Be- und Entstückautomat nach einem der Ansprüche 1 bis 10, d a d u r c h  g e k e n n z e i c h n e t, daß der Be- und/oder Entstückkopf (2, 5) über eine Keilwelle (73) mit einem Zahnrad (71) verbunden ist, das mittels der,an der dem Zahnrad (71) zugewandten Seite als Zahnstange (72) ausgeführten Zangendrehschubstange (45) drehbar ist.

FIG 1

FIG 2

FIG 3

FIG 4

**FIG 5**

**FIG 6**

FIG 7

# FIG 8

Nocke 14, Hub
Nocke 15, Zange
Nocke 16, 90° Dreh.
Nocke 50, 60° Schwenk
Nocke 18, Hub
Nocke 19, Zange
Nocke 20, 90° Dreh.
Nocke 24, Verschieben

6/6

0065299